# EUROPÄISCHE PATENTSCHRIFT

(11) **EP 1 069 810 B1**
(45) Veröffentlichungstag und Bekanntmachung des Hinweises auf die Patenterteilung: **08.09.2004**
(21) Anmeldenummer: 99113394.3
(22) Anmeldetag: 10.07.1999
(51) Int. Cl.: H05K 3/32, H05K 3/34

(54) **Leiterplatte mit mindestens einem elektronischen Bauteil und Verfahren zur Herstellung einer Verbindung zwischen Leiterplatte und Bauteil**
Printed circuit with at least one electronic component and method for connecting them
Circuit imprimé avec au moins un composant électronique et procédé de réalisation de leur connection

(43) Veröffentlichungstag der Anmeldung: 17.01.2001
(73) Patentinhaber: Endress + Hauser GmbH + Co. KG., 79689 Maulburg (DE)
(72) Erfinder: Lopatin, Sergej, Dr., 79539 Lörrach (DE); Birgel, Dietmar, 79560 Schopfheim (DE); Hauptvogel, Karl-Peter, 68870 Bartenheim (FR)
(74) Vertreter: Andres, Angelika

(56) Entgegenhaltungen:
- US-A- 5 487 211
- US-A- 5 639 010
- US-A- 5 641 995
- PATENT ABSTRACTS OF JAPAN vol. 16, no. 73 (E-1169), 21. Februar 1992 (1992-02-21) & JP 03 263360 A (SEIKO EPSON CORP), 22. November 1991 (1991-11-22)
- PATENT ABSTRACTS OF JAPAN vol. 4, no. 162 (E-033), 12. November 1980 (1980-11-12) & JP 55 110415 A (NOTO DENSHI KOGYO KK), 25. August 1980 (1980-08-25)
- PATENT ABSTRACTS OF JAPAN vol. 12, no. 63 (E-585), 25. Februar 1988 (1988-02-25) & JP 62 207009 A (MATSUSHIMA KOGYO CO), 11. September 1987 (1987-09-11)
- J. H. VINCENT ET AL.: "Lead-free solders for electronic assembly" GEC JOURNAL OF RESEARCH., Bd. 11, Nr. 2, 1994, Seiten 76-89, XP000454473 GEC MARCONI RESEARCH CENTER. GREAT BADDOW CHEMSFORD., GB ISSN: 0264-9187

## Beschreibung

Die Erfindung betrifft eine Lei terplatte mit mindestens einem elektronischen Bauteil und ein Verfahren zur Herstellung einer Verbindung zwischen Leiterplatte und jedem Bauteil. Die Verbindung bewirkt sowohl die mechanische Befestigung des Bauteils auf der Leiterplatte als auch den elektrischen Anschluß des Bauteils auf der Leiterplatte.

Moderne elektrische Geräte, insb. Meßgerät, weisen in der Regel mindestens eine Leiterplatte auf, auf der elektronische Bauteile angeordnet sind. Diese Bauteile müssen mechanisch auf der Leiterplatte befestigt werden und elektrisch an in oder auf der Leiterplatte verlaufenden Leitungen angeschlossen werden. Zur Reduktion von Herstellungskosten werden vorzugsweise oberflächenmontierbare Bauteile, sogenannte 'Surface Mounted Devices' - kurz SMD Bauteile eingesetzt. SMD Bauteile benötigen für deren Montage keine Leiterplattenlöcher, sondern werden mit ihren Kontakten direkt an vorgesehenen Anschlüssen angelötet. SMD-Bauteile können mit Bestückungsautomaten maschinell auf der Leiterplatte plaziert werden.

Typischerweise wird in einem ersten Schritt an allen Orten, an denen nachfolgend Bauteile positioniert werden, im Siebdruckverfahren eine Lotpaste auf die Leiterplatte aufgebracht. Ein Ort an dem Lot aufgebracht ist bzw. an dem nach Beendigung des Fertigungsprozesses eine Lötverbindung besteht ist nachfolgend als Lötstelle bezeichnet.

In einem nächsten Schritt werden die Leiterplatten maschinell mit den Bauteilen bestückt. Die bestückten Leiterplatten werden in einen Ofen eingebracht. Der Lötvorgang wird in einem Ofen, z.B. in einer Schutzgasatmosphäre, vorgenommen, indem ein lotspezifischer Temperaturzyklus durchlaufen wird.

Alternativ kann das Aufbringen von Lot und der Lötprozeß auch durch ein Lötbad vorgenommen werden. Da die Lötstellen sich zwischen Leiterplatte und Bauteil befinden, muß die Leiterplatte hierzu so in das Lötbad eingebracht werden, daß die Bauteile in das Bad hinein weisen. Damit die Bauteile nicht ins Bad fallen werden sie vor dem Einbringen der Leiterplatte in das Lötbad mit einem Kleber auf der Leiterplatte befestigt. Es muß ein Kleber verwendet werden, der der Temperatur des Lötbades, üblicherweise wird eine flüssige Zinnlegierung verwendet, standhält. Solche Kleber sind im Handel erhältlich. Damit sie ihre Klebwirkung entfalten müssen sie jedoch nach dem Aufbringen auf eine Klebstelle aushärten. Typischerweise müssen sie hierzu erwärmt werden. Vor dem Lötvorgang muß also ein zusätzlicher Arbeitsgang, nämlich das Ankleben der Bauteile durchgeführt werden. Der Kleber dient hier ausschließlich der mechanischen Befestigung der Bauteile.

Viele Geräte, z.B. Meßgeräte beispielsweise zur Messung von Druck, Temperatur, Füllstand, Druck oder Durchfluß, werden in Anwendungen eingesetzt, in denen sehr hohe Temperaturen auftreten können. Derartige Anwendungen treten z.B. in der Chemie und in der Lebensmittelindustrie auf. So können z.B. in der Lebensmittelindustrie bei Reinigungs- bzw. Sterilisierprozessen Temperaturen von über 100°C auftreten.

Es sind z.B. Füllstandsgrenzschalter im Handel erhältlich, die zur Grenzstanddetektion, als Überfüllsicherung oder als Pumpenleerlaufschutz verwendet werden. Diese weisen z.B. ein in einen Behälter ragendes mechanisches Schwingungsgebilde auf, das mittels eines piezoelektrischen Elements in Schwingungen versetzt wird. Es wird die Resonanzfrequenz und/oder die Amplitude einer angeregten Schwingung aufgenommen und daraus ermittelt, ob das Schwingungsgebilde frei schwingt oder von einem Füllgut bedeckt ist. In der Europäischen Patentanmeldung mit der Anmeldenummer 98117077 ist ein Füllstandsgrenzschalter beschrieben, bei dem das Schwingungsgebilde zwei in den Behälter ragende auf einer Membran befestigte Schwingstäbe aufweist. Auf der von den Schwingstäben abgewandten Seite der Membran ist ein piezoelektrisches Element befestigt, z.B. aufgeklebt, durch das die Membran und damit auch die Schwingstäbe in Schwingung versetzt werden.

Auf dessen membran-abgewandter Seite ist das piezoelektrische Element elektrisch und mechanisch mit einer flexiblen Leiterplatte verbunden. Auf dieser Leiterplatte sind neben dem piezoelektrischen Element elektronische Bauteile, vorzugsweise SMD-Bauteile, angeordnet. Dies sind z.B. Strom und Spannung begrenzende Elemente oder aber auch Teile einer Signalaufnahme und/oder Signalverarbeitungsschaltung. Bei der Herstellung dieses Aufbaus wurde bisher zunächst die Leiterplatte mit SMD-Bauteilen bestückt, es wurden die SMD-Bauteil verlötet und nachfolgend das piezoelektrische Element montiert.

Neben dem vorgenannten Beispiel gibt es eine Vielzahl von weiteren Anwendungen, bei denen neben SMD-Bauteilen andere elektronische Bauteile auf ein und derselben Leiterplatte anzuordnen sind. Dabei ist es natürlich wünschenswert, alle Bauteile möglichst in einem Arbeitsgang maschinell und in Serienfertigung mit der Leiterplatte elektrisch und mechanisch zu verbinden.

Lötverbindungen sind jedoch nur bei niedrigen Temperaturen, z.B. Temperaturen die deutlich unter 150 °C liegen, stabil. Oberhalb einer lotspezifischen Temperaturobergrenze wird das Lot weich und die mechanische und elektrische Verbindung ist nicht mehr zuverlässig gewährleistet. Dieser Nachteil wirkt sich bei piezoelektrischen Elementen aufgrund der mechanischen Schwingungen des piezoelektrischen Elements bereits bei niedrigeren Temperaturen aus als bei herkömmlichen SMD-Bauteilen da die Verbindung mechanischen Belastungen ausgesetzt ist.

Es sind Kleber im Handel erhältlich, durch die Verbindungen erzielbar sind, die auch bei höheren Temperaturen, z.B. bei Temperaturen um 150° C, noch zuverlässige mechanische Verbindungen gewährleisten. Einige dieser handelsüblichen Kleber sind elektrisch leitfähig, so daß bei deren Verwendung gleichzeitig eine elektrische Verbindung besteht.

Diese Kleber sind in der Regel sehr dünnflüssig und müssen nach deren Aufbringung auf eine gewünschte Klebestelle aushärten bevor sie zunächst eine Haftwirkung und im voll ausgehärteten Zustand eine Klebewirkung entfalten. Sie sind daher nicht für eine schnelle Serienfertigung geeignet. Ein Transport und/oder eine Weiterverarbeitung einer aus einer Leiterplatte und mindestens einem elektrischen Bauteil bestehenden Baueinheit ist erst möglich, wenn der Kleber soweit ausgehärtet ist, daß er zumindest eine Haftwirkung entfaltet.

Eine Leiterplatte mit den im ersten Teil des Anspruchs 1 genannten Merkmalen ist aus US-A-5 641 995 bekannt.

Es ist eine Aufgabe der Erfindung, eine Leiterplatte mit mindestens einem elektrischen Bauteil und ein Verfahren zur Herstellung einer Verbindung zwischen Leiterplatte und Bauteil derart anzugeben, daß eine schnelle maschinelle Serienfertigung möglich ist und die Leiterplatte bei höheren Temperaturen einsetzbar ist.

Hierzu besteht die Erfindung in einer Leiterplatte auf der mindestens ein elektronisches Bauteil angeordnet ist, welches Bauteil mindestens zwei elektrische Kontakte aufweist von denen ein erster mit einem ersten Anschluß auf der Leiterplatte durch eine Klebung mit einem leitfähigen Kleber und ein zweiter mit einem zweiten Anschluß auf der Leiterplatte durch eine Lötung verbunden ist, wobei die elektrischen Kontakte zu einer Elektrode gehören.

Gemäß einer Weiterbildung der Erfindung ist mindestens ein Bauteil ein piezoelektrisches Element.

Gemäß einer Ausgestaltung der Erfindung ist das Lot bleifrei und weist einen Silberanteil auf.

Gemäß einer weiteren Ausgestaltung ist das Lot ein Zinn-Silber-Lot.

Gemäß einer weiteren Ausgestaltung ist die Leiterplatte eine flexible Leiterplatte, insb. aus Polyimid.

Gemäß einer weiteren Ausgestaltung bestehen die Anschlüsse aus auf der Leiterplatte angeordneten Kupferpads, die vorzugsweise mit Nickel/Gold Anschlußmetallisierung oder einer Zinnschicht versehen sind.

Weiter besteht die Erfindung in einem Verfahren zur Herstellung einer Verbindung zwischen einer Leiterplatte und mindestens einem elektronischen Bauteil mit zwei elektrichen Kontakten, die zu einer Elektrode gehören für eine Leiterplatte gemäß der Erfindung, bei dem
- auf jeder für ein Bauteil vorgesehenen Fläche der Leiterplatte räumlich getrennt voneinander Lot auf Lötstellen und leitfähiger Kleber auf Klebestellen aufgebracht werden,
- die Bauteile auf die zugehörigen Flächen aufgesetzt werden,
- die Leiterplatte mit den Bauteilen in einen Ofen eingebracht wird und
- im Ofen ein Temperaturzyklus durchlaufen wird, durch den eine Lotverbindung zwischen dem Bauteil und der Leiterplatte entsteht und der Kleber seine Klebwirkung entfaltet.

Gemäß einer Weiterbildung des Verfahrens sind die Bauteile SMD-Bauteile oder Bauteile, bei denen alle Kontakte, die an eine Leiterplatte anzuschließen sind in einer Ebene auf einer Seite des Bauteils angeordnet sind und als plane Flächen ausgebildet sind. Die Bauteile werden maschinell auf die Leiterplatte aufgesetzt.

Gemäß einer Ausgestaltung des Verfahrens wird das Lot maschinell im Siebdruckverfahren und der Kleber mit einem Dispenser aufgebracht.

Die Erfindung und weitere Vorteile werden nun anhand der Figuren der Zeichnung, in denen zwei Ausführungsbeispiele dargestellt sind, näher erläutert; gleiche Elemente sind in den Figuren mit gleichen Bezugszeichen versehen.
- Fig. 1: zeigt schematisch eine Leiterplatte mit einem SMD-Bauteil und
- Fig. 2: zeigt schematisch eine Leiterplatte mit einem piezoelektrischen Element.

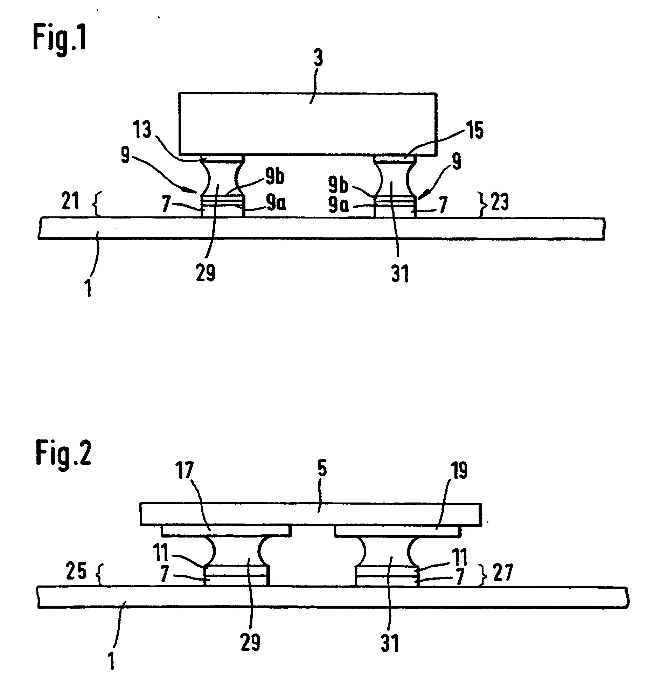

Die Figuren 1 und 2 zeigen jeweils eine Leiterplatte 1 mit einem elektronischen Bauteil. In dem in Fig. 1 gezeigten Ausführungsbeispiel ist das Bauteil ein herkömmliches SMD-Bauteil 3 und in dem in Fig. 2 dargestellten Ausführungsbeispiel ein piezoelektrisches Element 5.

Die Leiterplatte 1 ist z.B. eine handelsübliche starre Leiterplatte, z.B. aus einem Isolierstoff auf Epoxidharzbasis, oder eine flexible Leiterplatte, z.B. aus Polyimid. Leiterbahnen der Leiterplatte bestehen üblicherweise aus Kupfer und weisen dort, wo ein Anschluß erfolgen soll freiliegende Kupferpads 7 auf.

Auf dem Kupferpad 7 kann, wie in Fig. 1 dargestellt, eine Anschlußmetallisierung 9 vorgesehen sein. Die Anschlußmetallisierung 9 besteht z.B. aus einer Nickelschicht 9a und einer Goldschicht 9b. Das Nickel wird galvanisch, das Gold chemisch aufgebracht. Dabei ist die Nickelschicht 9a zwischen dem Kupferpad 7 und der Goldschicht 9b anzuordnen. Sie dient als Diffusionsbarriere und verhindert ein abwandern von Kupfer in die Goldschicht 9b. Diese Art der Oberflächenverbesserung wird häufig bei Lötverbindungen eingesetzt. Da die Goldschicht 9b eine sehr glatte ebene Oberfläche aufweist ist sie auch für das Kleben sehr gut geeignet.

Alternativ kann, wie in Fig. 2 dargestellt, eine Heißluftverzinnung zur Verbesserung der Löteigenschaften vorgenommen werden. Dabei wird Zinn auf die Kupferpadoberfläche im Tauchbad aufgebracht und mittels Heißluft abgeblasen. Das flüssige Zinn bildet eine sehr plane Oberfläche aus, die für einen nachfolgenden Lötvorgang vorteilhaft ist. Die plane Zinnschicht ist in Fig. 2 mit dem Bezugszeichen 11 versehen. Das Verfahren wird auch als Hot-Air-Leveling (HAL) bezeichnet. Auch hier gilt, daß die plane Oberfläche für das Kleben ebenfalls vorteilhaft ist.

Beide Arten der Oberflächenaufbereitung, sowohl die Anschlußmetallisierung als auch die Heißluftverzinnung sind somit für das Löten und das Kleben gut geeignet. Es kann somit an Löt- und Klebstellen einheitlich vorgegangen werden. Eine Unterscheidung, die fertigungstechnisch gesehen einen zusätzlichen Aufwand bedeuten würde, ist nicht erforderlich.

Erfindungsgemäß weist jedes Bauteil mindestens zwei elektrische Kontakte auf. Das in Fig. 1 dargestellte SMD-Bauteil 3 weist einen ersten und einen zweiten Kontakt 13, 15 auf. Kontakte von handelsüblichen SMD-Bauteilen bestehen aus einer Zinn-Blei-Legierung.

Das in Fig. 2 dargestellte piezoelektrische Element 5 weist ebenfalls einen ersten und einen zweiten Kontakt 17, 19 auf. Dies sind auf das Element aufgebrachte Elektroden. Es sind hier zwei getrennte Elektroden dargestellt. Erfindungsgemäß wird jedoch eine einzige Elektrode an mehreren Stellen kontaktiert, d.h. eine Elektrode weist mehrere Kontakte auf. Die Elektrode besteht vorzugsweise aus Silber.

Die in Fig.1 und 2 dargestellten Leiterplatten 1 weisen ebenfalls jeweils einen ersten und einen zweiten Anschluß 21, 23, 25, 27 auf. Der erste und der zweite Anschluß 21, 23 bestehen bei dem in Fig. 1 gezeigten Ausführungsbeispiel jeweils aus dem Kupferpad 7 und der darauf aufgebrachten Anschlußmetallisierung 9. Bei dem in Fig. 2 gezeigten Ausführungsbeispiel bestehen der erste und der zweite Anschluß 25, 27 jeweils aus dem Kupferpad 7 und der Zinnschicht 11.

Es ist bei beiden Ausführungsbeispielen jeweils der erste Kontakt 13, 17 mit dem zugeordneten ersten Anschluß 21, 25 auf der Leiterplatte 1 durch eine Klebung 29 mit einem leitfähigen Kleber und der zweite Kontakt 15, 19 mit dem zugeordneten zweiten Anschluß 23, 27 auf der Leiterplatte 1 durch eine Lötung 31 verbunden.

Bei dem SMD-Bauteil von Fig. 1 grenzen Lot und Kleber an die Kontakte 13, 15 aus Zinn-Blei und bei dem piezoelektrischen Element 5 von Fig. 2 grenzen Lot und Kleber an die Kontakte 17, 19 aus Silber.

Bei einer Leiterplatte auf der mehrere Bauteile mit Kontakten aus unterschiedlichen Materialien anzuordnen sind, werden vorzugsweise ein einziges Lot und ein einziger Kleber eingesetzt, das bzw. der gut mit den unterschiedlichen Materialien zusammenarbeitet.

Bei einer Leiterplatte auf der z.B. ein oder mehrere SMD-Bauteile und ein oder mehrere piezoelektrisches Elemente wie sie anhand der Figuren 1 und 2 beschrieben wurden nebeneinander anzuordnen sind, werden vorzugsweise ein Lot und ein Kleber eingesetzt, die jeweils sowohl mit Silber als auch mit Zinn-Blei-Legierungen gut zusammenarbeiten. Besonders geeignet ist ein Lot das einen Silberanteil aufweist. Sehr gute Ergebnisse werden mit einem Zinn-Silber-Lot erzielt. Auch der leitfähige Kleber weist vorzugsweise einen Silberanteil auf. Es kann z.B: der Kleber Amicon CE 3511 von Grace Emerson Cuming verwendet werden. Durch den Silberanteil in Lot und Kleber wird verhindert, daß Silber der Elektroden der piezoelektrischen Elemente in das Lot bzw. in den Kleber abwandert. Der Silberanteil schützt somit die Verbindung zwischen den Silberelektroden und den piezoelektrischen Elementen.

Das Lot ist vorzugsweise bleifrei. Blei weist einen niedrigen Schmelzpunkt auf und führt dazu, daß mit bleihaltigen Loten nur bei niedrigen Temperaturen stabile Verbindungen herstellbar sind. Ein Zinn-Blei-Lot weist eine Schmelzpunkt von ca. 180°C auf, bei einem Zinn-Silber-Lot liegt der Schmelzpunkt dagegen bei ca. 220°C.

Die in den beiden Ausführungsbeispielen dargestellte Verbindung zwischen Leiterplatte und mindestens einem elektronischen Bauteil wird erfindungsgemäß hergestellt, indem zunächst auf jeder für ein Bauteil vorgesehenen Fläche der Leiterplatte räumlich getrennt voneinander Lot auf Lötstellen und Kleber auf Klebestellen aufgebracht werden. Vorzugsweise wird das Lot maschinell im Siebdruckverfahren und der Kleber mit einem Dispenser aufgebracht.

In einem nächsten Schritt werden die Bauteile auf die zugehörigen Flächen aufgesetzt. Die Bauteile sind vorzugsweise SMD-Bauteile oder aber Bauteile die als solche behandelbar sind. Sind alle Bauteile zumindest als SMD-Bauteil behandelbar, so können sie maschinell auf die Leiterplatte aufgesetzt werden Dieser Arbeitsgang wird von einem Bestückungsautomaten vorgenommen.

Ein Bauteil ist als SMD-Bauteil behandelbar, wenn alle Kontakte die an eine Leiterplatte anzuschließen sind in einer Ebene auf einer Seite des Bauteils angeordnet sind und als plane Flächen ausgebildet sind.

Es ist möglich ein piezoelektrisches Element fertigungstechnisch wie ein SMD-Bauteil zu behandeln. Damit kann die Bestückung und die Verbindung der Leiterplatte mit piezoelektrischen Elementen maschinell in Serienfertigung erfolgen.

Aufgrund der Naßklebekraft des Lotes sind alle Bauteile auf der Leiterplatte fixiert und die Leiterplatte kann sofort nach deren Bestückung transportiert werden. Damit ist es möglich, die Leiterplatten während des gesamten Herstellprozesses über Förderbänder zu transportieren. Vibrationen, wie sie bei dieser Transportart zwangsläufig auftreten führen nicht zu einem verrutschen oder gar zum Verlust von Bauteilen. Gegebenenfalls erforderliche weitere Arbeitsgänge können sofort ausgeführt werden.

Nachfolgend wird die Leiterplatte mit den Bauteilen in einen Ofen eingebracht. Aufgrund der Naßklebekraft des Lotes kann dies unmittelbar im Anschluß an die Bestückung der Leiterplatte mit den Bauteilen und über ein Förderband erfolgen. Im Ofen wird ein Temperaturzyklus durchlaufen, durch den eine elektrische und mechanische Lot- und Klebeverbindung zwischen jedem Bauteil und der Leiterplatte entsteht. Durch die Erwärmung schmilzt das Lot und der Kleber wird ausgehärtet. Kleb- und Lötverbindung werden somit in einem einzigen Arbeitsgang gleichzeitig bewirkt.

Die dabei auftretenden Temperaturen sind für piezoelektrische Elemente nicht nur nicht von Nachteil, sondern sogar von Vorteil. Sofern piezoelektrische Elemente nur auf die beschriebene Weise mit der Leiterplatte verbunden sind und nicht mechanisch fest eingespannt sind, tritt bei den zum Kleben und Löten erforderlichen Temperaturen keine merkliche Depolarisation piezoelektrischer Elemente auf. Es treten jedoch Setzeffekte ein, die ein künstliches voraltern der piezoelektrischen Elemente bewirken. Alterungs- bzw. Ermüdungserscheinungen sind somit direkt nach der Herstelllung erfaßbar und können z.B. bei einem Abgleich der Schaltung in der ein solches piezoelektrisches Element enthalten ist oder bei der Erstkalibration eines Geräts in das die Leiterplatte eingebracht ist mit berücksichtigt werden.

Die verbleibenden freien Oberflächen der piezoelektrischen Elemente werden durch die Erwärmung gereinigt. Dies ist z.B. dann von Vorteil, wenn ein solches piezoelektrisches Element nachfolgend zusammen mit der Leiterplatte an einem Einsatzort eingeklebt werden soll. Auf sauberen Oberflächen kann ein Kleber besser haften.

Tests haben gezeigt, daß die beschriebene Verbindung bezüglich deren elektrischen und mechanischen Eigenschaften hervorragenden Ergebnisse liefert. Dabei wurden Leiterplatten mit damit verbundenen Bauteilen zyklisch extremen Temperaturwechseln ausgesetzt. Zur Überprüfung der elektrischen Eigenschaften wurde der Übergangswiderstand der Verbindungen aufgenommen und zur Überprüfung der mechanischen Eigenschaften wurden Scher- und Schälbelastungstests durchgeführt.

Die Scherfestigkeit der Klebstellen ist deutlich größer als die der Lötstellen. Demgegenüber zeigen die Lötstellen eine höhere Festigkeit als die Klebstellen wenn sie auf Schälung belastet, d.h. mit einer Normalkraft beaufschlagt, werden. Die Verbindung zwischen Bauteil und Leiterplatte ist also gegenüber beiden mechanischen Belastungsarten widerstandsfähig. Mit zunehmenden Temperaturen wächst der Anteil den die Klebverbindung an der mechanischen Belastbarkeit hat allerdings.

Da je nach mechanischer Belastungsart die Lötstelle die Klebestelle schützt und umgekehrt ist die Verbindung deutlich länger haltbar als in der Beschreibungseinleitung angeführte herkömmliche Verbindungen.

Die Widerstandsmessungen zeigten, daß keine erkennbare belastungsbedingte Schädigung der Löt- und Klebestellen auftrat. Dies ist sicherlich zumindest zum Teil auf die hohe mechanische Belastbarkeit der Verbindung zurückzuführen.

| | |
|---|---|
| 1 | Leiterplatte |
| 3 | SMD-Bauteil |
| 5 | Piezoelektrisches Element |
| 7 | Kupferpad |
| 9 | Anschlußmetallisierung |
| 11 | Zinnschicht |
| 13 | Erster Kontakt |
| 15 | Zeiter Kontakt |
| 17 | Erster Kontakt |
| 19 | Zeiter Kontakt |
| 21 | Erster Anschluß |
| 23 | Zeiter Anschluß |
| 25 | Erster Anschluß |
| 27 | Zeiter Anschluß |
| 29 | Klebung |
| 31 | Lötung |

## Patentansprüche

1. Leiterplatte (1) auf der mindestens ein elektronisches Bauteil (3, 5) angeordnet ist, welches Bauteil (3, 5) mindestens zwei elektrische Kontakte (13, 15, 17, 19) aufweist von denen ein erster mit einem ersten Anschluß (21, 25) auf der Leiterplatte (1) durch eine Klebung (29) mit einem leitfähigen Kleber und ein zweiter mit einem zweiten Anschluß (23, 27) auf der Leiterplatte (1) durch eine Lötung (31) verbunden ist, **dadurch gekennzeichnet, dass** die elektrischen Kontakte (17, 19) zu einer Elektrode gehören.

2. Leiterplatte (1) nach Anspruch 1, bei der mindestens ein Bauteil (5) ein piezoelektrisches Element (5) ist.

3. Leiterplatte (1) nach Anspruch 1, bei dem das Lot bleifrei ist und einen Silberanteil aufweist.

4. Leiterplatte (1) nach Anspruch 3, bei dem das Lot ein Zinn-Silber-Lot ist.

5. Leiterplatte (1) nach Anspruch 1, bei dem die Leiterplatte (1) eine flexible Leiterplatte, insb. aus Polyimid, ist.

6. Leiterplatte (1) nach Anspruch 1, bei der die Anschlüsse (21, 23, 25, 27) aus auf der Leiterplatte (1) angeordneten Kupferpads (7) bestehen.

7. Leiterplatte (1) nach Anspruch 6, bei der die Kupferpads (7) mit einer Nickel/Gold Anschlußmetallisierung (9) oder einer Zinnschicht (11) versehen sind.

8. Verfahren zur Herstellung einer Verbindung zwischen einer Leiterplatte (1) und mindestens einem elektronischen Bauteil (3, 5) mit zwei elektrischen Kontakten (17, 19), die zu einer Elektrode gehören, für eine Leiterplatte (1) gemäß einem der vorangehenden Ansprüche, bei dem
- auf jeder für ein Bauteil (3, 5) vorgesehenen Fläche der Leiterplatte (1) räumlich getrennt voneinander Lot auf Lötstellen und leitfähiger Kleber auf Klebestellen aufgebracht werden,
- die Bauteile (3, 5) auf die zugehörigen Flächen aufgesetzt werden,
- die Leiterplatte (1) mit den Bauteilen (3, 5) in einen Ofen eingebracht wird und
- im Ofen ein Temperaturzyklus durchlaufen wird, durch den eine Lotverbindung (31) zwischen dem Bauteil (3, 5) und der Leiterplatte (1) entsteht und der Kleber seine Klebwirkung entfaltet.

9. Verfahren nach Anspruch 8, bei dem die Bauteile (3, 5) SMD-Bauteile (3) sind oder Bauteile (5) sind, bei denen alle Kontakte (17, 19) die an eine Leiterplatte anzuschließen sind in einer Ebene auf einer Seite des Bauteils (5) angeordnet sind und als plane Flächen ausgebildet sind, und bei dem die Bauteile (3, 5) maschinell auf die Leiterplatte (1) aufgesetzt werden.

10. Verfahren nach Anspruch 8, bei dem das Lot maschinell im Siebdruckverfahren und der Kleber mit einem Dispenser aufgebracht wird.

11. Verfahren nach Anspruch 8, bei dem das Bauteil (3, 5) zusammen mit der Leiterplatte (1) an einem Einsatzort eingeklebt wird.

## Claims

1. A printed circuit board (1) on which at least one electronic component (3, 5) is arranged, which component (3, 5) has at least two electrical contacts (13, 15, 17, 19), of which a first is connected to a first terminal (21, 25) on the printed circuit board (1) by means of a glued joint (29) using a conductive adhesive and a second is connected to a second terminal (23, 27) on the printed circuit board (1) by means of a soldered joint (31), **characterised in that** the electrical contacts (17, 19) form part of an electrode.

2. A printed circuit board (1) according to claim 1, wherein at least one component (5) is a piezoelectric element (5).

3. A printed circuit board (1) according to claim 1, wherein the solder is lead-free and has a silver content.

4. A printed circuit board (1) according to claim 3, wherein the solder is a tin-silver solder.

5. A printed circuit board (1) according to claim 1, wherein the printed circuit board (1) is a flexible printed circuit board, in particular comprising polyimide.

6. A printed circuit board (1) according to claim 1, wherein the terminals (21, 23, 25, 27) comprise copper pads (7) arranged on the printed circuit board (1).

7. A printed circuit board (1) according to claim 6, wherein the copper pads (7) are provided with a nickel/gold terminal metallisation (9) or a tin layer (11).

8. A method of producing a connection between a printed circuit board (1) and at least one electronic component (3, 5) having two electrical contacts (17, 19) forming part of an electrode, for a printed circuit board (1) according to any one of the preceding claims, wherein
- on each surface of the printed circuit board (1) provided for a component (3, 5), spatially separated from one another, solder is applied to soldering points and conductive adhesive is applied to adhesion points,
- the components (3, 5) are placed onto the associated surfaces,
- the printed circuit board (1) with the components (3, 5) is placed into a furnace, and
- in the furnace a temperature cycle is passed through, as a result of which a soldered joint (31) is produced between the component (3, 5) and the printed circuit board (1), and the adhesive deploys its adhesive effect.

9. A method according to claim 8, wherein the components (3, 5) are SMD components (3) or are components (5) in which all the contacts (17, 19) to be connected to a printed circuit board are arranged in one plane on one side of the component (5) and are formed as planar surfaces, and wherein the components (3, 5) are mechanically placed onto the printed circuit board (1).

10. A method according to claim 8, wherein the solder is mechanically applied by screen printing and the adhesive is applied by means of a dispenser.

11. A method according to claim 8, wherein the component (3, 5) is glued in together with the printed circuit board (1) *in situ.*

## Revendications

1. Carte de circuit imprimé (1) sur laquelle on a disposé au moins un élément (3, 5) électronique, lequel élément (3, 5) présente au moins deux contacts électriques (13, 15, 17, 19) parmi lesquels au moins un contact est relié avec une première connexion (21, 25) à la carte de circuit imprimé (1) par un collage (29) avec une colle conductrice et un deuxième contact est relié avec une deuxième connexion (23, 27) à la carte de circuit imprimé (1) par brasage (31), **caractérisée en ce que** les contacts électriques (17, 18) appartiennent à une électrode.

2. Carte de circuit imprimé (1) selon la revendication 1, pour laquelle au moins un élément (5) est un élément piézoélectrique (5).

3. Carte de circuit imprimé (1) selon la revendication 1, pour laquelle le brasage est sans plomb et présente une part d'argent.

4. Carte de circuit imprimé (1) selon la revendication 3, pour laquelle le brasage est un matériau de brasage étain - argent.

5. Carte de circuit imprimé (1) selon la revendication 1, pour laquelle la carte de circuit imprimé (1) est une carte de circuit imprimé flexible, notamment en polyimide.

6. Carte de circuit imprimé (1) selon la revendication 1, pour laquelle les connexions (21, 23, 25, 27) sont constituées de pastilles en cuivre (7) disposés sur la carte de circuit imprimé (1).

7. Carte de circuit imprimé (1) selon la revendication 6, pour laquelle les pastilles en cuivre (7) sont pourvues d'une métallisation de connexion (9) en nickel/or ou d'une couche d'étain (11 ).

8. Procédé pour fabriquer une liaison entre une carte de circuit imprimé (1) et au moins un élément électronique (3, 5) avec deux contacts électriques (17, 19) qui appartiennent à une électrode, pour une carte de circuit imprimé (1) conformément à une des revendications précédentes, pour laquelle :
- sur chaque surface prévue pour un élément (3, 5) de la carte de circuit imprimé (1), on a appliqué le matériau de brasage sur les zones de brasage et une colle conductrice sur les zones de collage, de façon séparé l'un de l'autre dans l'espace,
- les éléments (3, 5) ont été placés sur les surfaces associées,
- la carte de circuit imprimé (1) a été insérée avec les éléments (3, 5) dans un four et
- on applique dans le four un cycle thermique grâce auquel il s'ensuit une liaison de brasage (31) entre l'élément (3, 5) et la carte de circuit imprimé (1) et la colle développe son effet de collage.

9. Procédé selon la revendication 8, pour lequel les éléments (3, 5) sont des éléments SMD (3) ou des éléments (5) pour lesquels tous les contacts (17, 19) qui doivent être connectés à une carte de circuit imprimé sont disposés dans un plan sur un côté de l'élément (5) et sont formés en tant que surfaces planes, et pour lequel les éléments (3, 5) sont placés de façon automatique sur la carte de circuit imprimé (1).

10. Procédé selon la revendication 8, pour lequel le matériau de brasage est appliqué de façon automatique dans le procédé de sérigraphie et la colle est appliquée avec un distributeur.

11. Procédé selon la revendication 8, pour lequel l'élément (3, 5) est collé ensemble avec la carte de circuit imprimé (1) à un endroit d'utilisation.
